Europäisches Patentamt

European Patent Office

Office européen des brevets

(19)

(11) EP 0 847 626 B1

(12) FASCICULE DE BREVET EUROPEEN

(45) Date de publication et mention
de la délivrance du brevet:
**16.06.1999 Bulletin 1999/24**

(21) Numéro de dépôt: **96929325.7**

(22) Date de dépôt: **26.08.1996**

(51) Int Cl.⁶: **H03M 1/40**, H03M 1/66

(86) Numéro de dépôt international:
**PCT/EP96/03752**

(87) Numéro de publication internationale:
**WO 97/08835 (06.03.1997 Gazette 1997/11)**

(54) **DISPOSITIF DE TRAITEMENT NUMERIQUE D'UN SIGNAL ANALOGIQUE DEVANT ETRE RESTITUE SOUS FORME ANALOGIQUE**

VORRICHTUNG ZUR DIGITALVERARBEITUNG EINES ANALOGSIGNALS, WELCHES AUCH WIEDER IN ANALOGER FORM AUSGEGEBEN WERDEN SOLL

DIGITAL PROCESSING DEVICE FOR AN ANALOG SIGNAL TO BE RESTORED IN ANALOG FORM

(84) Etats contractants désignés:
**AT BE CH DE DK ES FI FR GB IE IT LI NL PT SE**

(30) Priorité: **29.08.1995 FR 9510174**

(43) Date de publication de la demande:
**17.06.1998 Bulletin 1998/25**

(73) Titulaire: **Soprintel S.A.**
**2300 La Chaux-de-Fonds (CH)**

(72) Inventeur: **HEUBI, Alexandre**
**CH-2300 La Chaux-de-Fonds (CH)**

(74) Mandataire: **Colas, Jean-Pierre et al**
**Cabinet de Boisse et Colas**
**37, avenue Franklin D. Roosevelt**
**75008 Paris (FR)**

(56) Documents cités:
EP-A- 0 213 954          EP-A- 0 214 831
EP-A- 0 251 758          GB-A- 2 223 137

**Description**

La présente invention est relative à un dispositif de traitement numérique d'une information se présentant sous une forme analogique et devant être restituée sous une forme analogique après avoir subi ce traitement numérique.

Plus précisément, l'invention concerne un convertisseur destiné à réaliser une conversion de signaux variables, soit dans le sens analogique/numérique, soit dans le sens numérique/analogique, ces signaux devant être utilisés dans des applications dans lesquelles leur conversion ne nécessite pas une précision absolue uniforme sur toute leur plage de variation.

Une application dans laquelle des conversions de ce type peuvent être admises est celle de l'aide auditive dont on équipe les malentendants.

Ces appareils nécessitent notamment une adaptation du spectre sonore environnant à la physiologie de l'oreille du porteur d'où la présence dans ces appareils de moyens de traitement des signaux reçus avant qu'ils puissent être transmis sur l'oreille par l'intermédiaire d'un transducteur sonore de restitution des sons. Le traitement étant relativement complexe et de façon avantageuse souvent particularisé pour chaque patient, il est souhaitable qu'il soit fait sur des signaux numériques, plutôt qu'analogiques. C'est en effet dans ces conditions qu'il peut être exécuté par des logiciels spécialement adaptés et facilement configurables de cas en cas. Une telle aide auditive doit ainsi pouvoir convertir les signaux utiles dans les deux sens, savoir analogique/numérique et le sens inverse.

Or, de nombreuses expériences ont montré que la qualité de la perception auditive peut s'accomoder d'un niveau de bruit allant jusqu'à 30 dB par rapport au signal utile. Par conséquent, il s'avère qu'une précision de conversion relative par rapport au signal utile est suffisante dans cette application particulière.

En d'autres termes, on aurait besoin d'une précision au niveau numérique bien inférieure à ce qui est communément admis pour la conversion de signaux sonores analogiques (habituellement 14 bits absolus) dans les installations sonores communément utilisées.

Une telle précision relative peut être obtenue en utilisant un convertisseur dit "à trois plages de décision". Un convertisseur de ce type dans le sens analogique/numérique est décrit dans un article de Bernard Ginetti et al., paru dans la revue "IEEE Journal of Solid-State Circuits", Vol 27, N° 7, Juillet 1992.

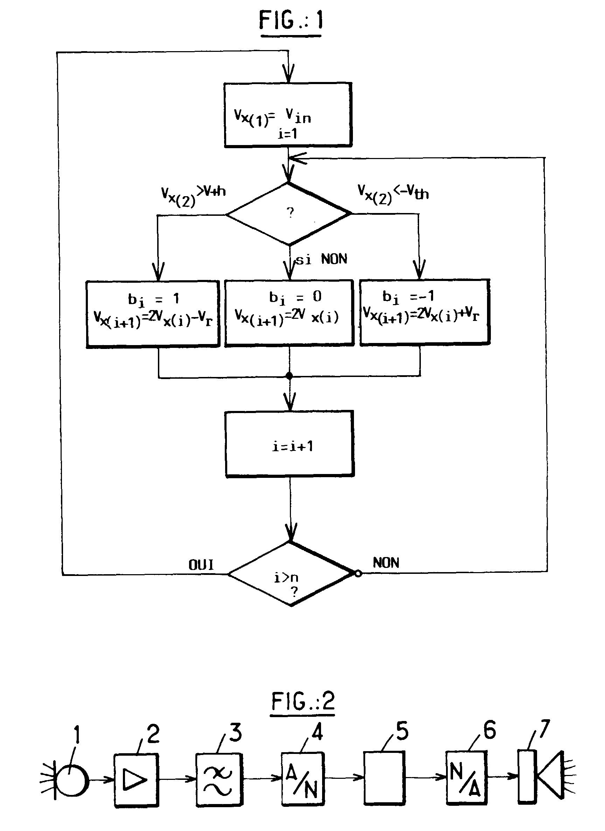

Dans cet article, on décrit d'abord l'algorithme mis en oeuvre dans un tel convertisseur. Cet algorithme est rappelé ici en se référant à la figure 1 des dessins annexés dans laquelle les notations suivantes sont utilisées:

- i = numéro d'itération de l'algorithme;
- $b_i$ = valeur binaire obtenue à chaque itération;
- $V_{in}$ = tension à convertir;

- $V_{x(1)}$ = valeur instantanée de $V_{in}$;
- $V_{x(i)}$ = tension intermédiaire de l'algorithme;
- $V_r$ = tension de référence;
- $V_{th}$ = tension de seuil;
- n = nombre total d'itérations pour une prise d'échantillon.

Dans son principe, cet algorithme de conversion cyclique revient au processus suivant. Chaque échantillon $V_{x(1)}$, de la tension d'entrée $V_{in}$ à convertir est multiplié par deux et le résultat de cette multiplication est comparé à une tension de référence. Si le signal est plus grand que cette tension de référence, le bit de plus grand poids du signal de sortie est porté à "1" et la tension de référence est soustraite de $V_{x(1)}$. Sinon, le bit de plus grand poids est porté à "0" et aucune opération arithmétique n'est exécutée. Le reste de la tension, $V_{x(2)}$, qui correspond en fait au reste partiel de la division, subit les mêmes opérations au cours de l'itération suivante et la boucle de l'algorithme se répète ainsi jusqu'à obtention du bit de poids le plus faible.

En fait, pour obtenir de meilleures performances de la conversion, notamment en matière de fréquence d'horloge et de simplification des composants nécessaires, on ajoute à ce processus, l'établissement d'une troisième valeur de b, en utilisant à chaque itération deux niveaux de comparaison, $+V_{th}$ et $-V_{th}$. Ainsi, si le signal $V_x$ est plus grand que $+V_{th}$, le bit de sortie est porté à "1" et la tension de référence est soustraite. Si le signal $V_x$ est plus petit que $-V_{th}$, le bit est porté à -1 et la tension $V_{th}$ est additionnée. Dans les autres cas, le bit est porté à "0" et aucune opération arithmétique n'est effectuée.

Dans l'article précité, on se préoccupe avant tout de proposer un circuit de mise en oeuvre de cet algorithme dans le but de réduire la précision minimale requise par la comparaison entre $\pm V_r$ et la tension 0 et l'erreur de décalage de boucle. Cette tentative des auteurs de l'article conduit à un circuit dont les performances sont excellentes mais qui dans certaines applications, et notamment celle des appareils auditifs dépassent les exigences requises en matière de précision de la conversion. Sous forme intégrée, un tel circuit est donc trop encombrant et un trop grand consommateur d'énergie pour le but que l'on doit se fixer.

L'invention est basée sur la considération que dans certaines applications et notamment dans celle des appareils auditifs, mais aussi certains autres domaines tels que l'"audiométrie" (la technique de mesure de l'audience d'une chaîne de radio ou de télévision) ou encore la téléphonie, on peut admettre, comme déjà indiqué ci-dessus, un rapport signal/bruit relativement important, ce qui permet dans la mise en oeuvre de l'algorithme de la figure 1, d'utiliser un circuit plus simple nécessitant moins de surface d'intégration, présentant une consommation plus faible et étant néanmoins compatible avec les qualités de conversion auxquelles on doit s'attendre dans l'application spécifique envisagée, telle que par exemple l'aide auditive.

L'invention a pour but de fournir un convertisseur de signaux qui soit simple, peu encombrant et d'une consommation des plus réduites.

L'invention a donc pour objet un convertisseur d'un signal d'entrée en un signal de sortie représentatif dudit signal d'entrée avec une précision relative, ce convertisseur mettant en oeuvre un algorithme de conversion à trois plages de décision impliquant des valeurs numériques ternaires $b_i$, avec $b_i = 1$, 0, ou -1, et comprenant une source de tension de référence, des moyens de calcul pour, au cours de chacune des itérations d'une suite d'itérations successives dudit algorithme, établir une valeur de tension formée de la somme d'une valeur établie sur la base de la tension calculée à l'itération précédente et d'une valeur qui est le produit de la valeur ternaire obtenue au cours de l'itération précédente et de ladite tension de référence, lesdits moyens de calcul comprenant à cet effet une pluralité de capacités commutées coopérant avec des moyens d'amplification délivrant ladite valeur de tension à chacune desdites itérations, ledit convertisseur comprenant également des moyens générateurs pour engendrer à partir des valeurs de tension successives calculées pendant ladite suite d'itérations des échantillons successifs représentant sous forme convertie ledit signal d'entrée, caractérisé en ce que lesdits moyens de calcul sont formés par un montage unilatéral de capacités commutées en combinaison avec un unique amplificateur opérationnel formant lesdits moyens d'amplification, l'une des entrées dudit amplificateur opérationnel étant connectée à un potentiel fixe, et en ce que ladite source de référence est agencée pour fournir une tension de référence unipolaire référencée sur ledit potentiel fixe.

Selon un premier mode de réalisation de l'invention, dans lequel lesdits signaux d'entrée sont analogiques et lesdits signaux de sortie sont numériques, lesdits moyens de calcul effectuent au cours de chacune desdites itérations, l'algorithme de la forme

$$V_{x_{i+1}} = 2V_{x_i} - b_iV_r$$

dans laquelle $V_{x_i}$ est la tension obtenue au cours de l'itération i précédente, $V_{x_{i+1}}$ est la tension à obtenir au cours de l'itération i+1 en cours, $b_i$ est la valeur ternaire -1, 0 ou +1 calculée et $V_r$ est la tension de référence, et en ce qu'il comprend également des moyens de comparaison pour comparer le signal de sortie dudit amplificateur opérationnel à une tension de référence bipolaire et un circuit logique de transformation pour transformer la sortie desdits moyens de comparaison en les valeurs ternaires utilisées à chaque itération.

Un convertisseur analogique/numérique présentant les caractéristiques énoncées ci-dessus ne nécessite qu'une seule tension de référence unipolaire facile à obtenir, contrairement à un montage dans lequel on aurait besoin d'une tension de référence pour chaque polarité dont les valeurs absolues ne pourraient être établies moyennant un circuit complexe d'appariement.

Par ailleurs, du fait que le montage est unilatéral, un seul amplificateur opérationnel suffit pour réaliser les moyens de calcul. Ceci conduit à une simplification appréciable du convertisseur et en réduit considérablement la consommation, propriété qui est très utile dans des appareils portables nécessairement miniaturisés, comme les aides auditives dans lesquelles la place réservée à la source d'énergie est généralement très réduite.

Dans l'article précité, on enseigne uniquement la réalisation d'un convertisseur analogique/numérique mettant en oeuvre l'algorithme précité au moyen d'un montage symétrique comprenant plusieurs amplificateurs opérationnels.

Cependant, la Demanderesse de la présente demande de brevet a constaté que l'algorithme de conversion à trois plages de décision peut, moyennant une adaptation adéquate, être utilisé avec profit pour opérer une conversion inverse numérique/analogique, dans les mêmes conditions que celles sous lesquelles travaille le convertisseur selon le premier mode de réalisation de l'invention.

Ainsi, suivant un second mode de réalisation de l'invention, dans lequel lesdits signaux d'entrée sont numériques et lesdits signaux de sortie sont analogiques, lesdits moyens de calcul effectuent au cours de chacune desdites itérations, l'algorithme de la forme

$$V_{x_{i+1}} = \frac{\left(V_{x_i} + b_iV_r\right)}{2}$$

dans laquelle $V_{x_i}$ est la portion de tension intermédiaire calculée au cours de l'itération i précédente, $V_{x_{i+1}}$ est la portion de tension intermédiaire à obtenir pendant l'itération i+1 en cours, $b_i$ est la valeur ternaire -1, 0 ou +1 calculée et $V_r$ est la tension de référence, et en ce qu'il comprend également des moyens de maintien pour conserver la tension cumulée obtenue au cours d'un cycle d'itérations précédentes pendant l'exécution d'un cycle d'itérations jusqu'à l'achèvement de celui-ci afin de délivrer les échantillons successifs de la tension analogique à obtenir.

Ce convertisseur numérique/analogique présente les mêmes avantages de simplicité et de faible consommation que le convertisseur suivant le premier mode de réalisation.

L'invention a également pour objet un dispositif électronique, notamment une aide auditive, comprenant des moyens de traitement numérique de signaux analogiques, devant être restitués sous une forme adaptée et également analogique après ce traitement et en combinaison avec des convertisseurs de signaux tels que définis ci-dessus.

D'autres caractéristiques et avantages de l'invention apparaîtront au cours de la description qui va suivre, donnée uniquement à titre d'exemple et faite en se référant aux dessins annexés sur lesquels:

- la figure 1 déjà décrite est la représentation d'un algorithme connu utilisé dans le convertisseur analogique/numérique selon l'invention;
- la figure 2 est un schéma très simplifié d'une aide auditive comportant deux convertisseurs, un de chaque type, selon l'invention;
- la figure 3 est un schéma plus détaillé du convertisseur analogique/numérique selon l'invention;
- la figure 4 est un diagramme des temps illustrant le fonctionnement du convertisseur selon la figure 3;
- la figure 5 est un graphique illustrant le fonctionnement des comparateurs utilisés dans le convertisseur de la figure 3;
- la figure 6 est un graphique montrant, en fonction de la tension appliquée au convertisseur, l'évolution du rapport signal/bruit par plusieurs courbes obtenues avec des méthodes de conversion différentes;
- la figure 7 représente l'organigramme mis en oeuvre par les moyens de calcul du convertisseur numérique/analogique suivant l'invention;
- la figure 8 est un schéma simplifié des moyens de calcul du convertisseur numérique/analogique selon l'invention; et
- la figure 9 est un diagramme des temps illustrant le fonctionnement du convertisseur selon la figure 8.

Sur la figure 2, on a représenté à titre d'exemple d'application avantageux de l'invention un mode de réalisation préféré d'une aide auditive dans laquelle sont utilisés deux convertisseurs.

Cette aide auditive comprend un microphone 1 captant l'environnement sonore, un amplificateur 2 à gain fixe recevant les signaux du microphone 1 et transmettant ce signal amplifié vers un filtre passe-bas 3 ayant une fréquence de coupure de 8000 Hz, par exemple. Le signal filtré issu du filtre 3 est appliqué à un convertisseur analogique/numérique 4 conçu selon l'invention et destiné à engendrer, à partir de ce signal, une suite de mots binaires codés selon la valeur des échantillons successifs pris de ce signal analogique.

La sortie du convertisseur 4 est appliquée à un processeur de signaux binaires 5 qui est destiné à traiter le spectre sonore représenté par les signaux binaires, notamment pour l'adapter à la physiologie de l'oreille du porteur de l'aide auditive.

Le processeur 5 est suivi d'un autre convertisseur 6 numérique/analogique selon l'invention et ce convertisseur est branché à la sortie du processeur 5 pour reconvertir le signal binaire transformé par celui-ci en un signal analogique. Ce signal est rendu audible par un haut-parleur 7 ou tout autre transducteur d'écoute approprié, pour le patient porteur de l'aide auditive.

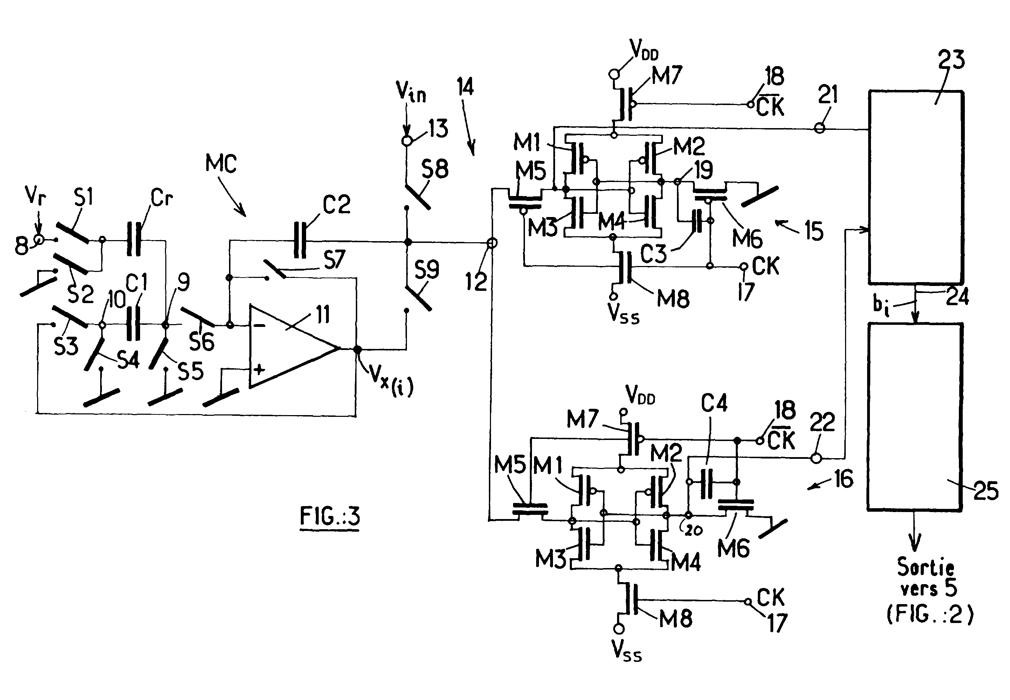

On va maintenant décrire le convertisseur analogique/numérique 4 selon l'invention en se reportant à la figure 3 qui en représente un exemple préféré. Cet exemple est réalisé avantageusement avec des condensateurs dits "capacités commutées" intégrées sur une même puce avec des transistors MOS qui forment des interrupteurs commandés.

Ainsi, ce convertisseur comprend des moyens de calcul désignés globalement par la référence MC et comprenant un premier condensateur Cr de référence connecté à une borne 8 du convertisseur 4 sur laquelle est appliquée une tension continue de référence $V_r$, par exemple la tension d'alimentation du montage, à travers un interrupteur S1. On notera que cette tension $V_r$ est unipolaire et la seule tension utilisée pour le calcul. Le condensateur Cr peut également être connecté sélectivement à la masse à travers un interrupteur S2. L'autre armature du condensateur de référence Cr est reliée à un noeud 9 auquel est relié un condensateur C1. L'armature opposée de ce condensateur C1 est reliée à un noeud 10 qui est connecté à deux interrupteurs S3 et S4. L'interrupteur S4 est connecté à la masse.

Le noeud 9 est relié à deux interrupteurs S5 et S6, l'interrupteur S5 étant également connecté à la masse. L'interrupteur S6 est connecté à l'entrée inverseuse d'un amplificateur opérationnel 11, dont l'entrée non inverseuse est reliée à la masse, c'est-à-dire à un potentiel fixe. On remarquera que cet amplificateur est le seul utilisé pour effectuer le calcul par l'algorithme.

Un condensateur C2 est branché entre l'entrée inverseuse de cet amplificateur 11 et un noeud 12. La sortie de l'amplificateur 11 est connectée d'une part à l'interrupteur S3 et d'autre part à un interrupteur S7 qui peut relier cette sortie à l'entrée inverseuse. Par ailleurs, le noeud 12 est relié à un interrupteur S8 permettant d'appliquer au condensateur C2 une tension $V_{in}$ fournie à partir d'une borne 13. Un interrupteur S9 est inséré entre le condensateur C2 et la sortie de l'amplificateur 11. Le noeud 12 est également connecté à un ensemble comparateur désigné globalement par la référence 14.

On notera à ce stade, que les moyens de calcul MC sont d'une conception "unilatérale" ce qui, au sens de la présente description, veut dire que tous les composants travaillent avec des polarités situées d'un côté d'une tension de base qui est ici la masse, la polarité étant arbitrairement choisie du côté positif. Il en résulte un circuit très simple qui, au prix d'une imprécision admissible, permet d'obtenir une conversion appropriée pour l'application envisagée. On notera également que ce montage ne comporte qu'un seul amplificateur opérationnel 11. Enfin, la tension de référence $V_r$ est unipolaire (et positive dans le cas représenté).

L'ensemble comparateur 14 comprend deux comparateurs 15 et 16 dont les schémas sont identiques à une exception près. Plus précisément, chaque comparateur comprend deux inverseurs (transistors M1 à M4) couplés en croix auxquels sont respectivement raccordés deux transistors de transfert M5 et M6 des signaux à comparer et deux transistors de transfert M7 et M8 des potentiels d'alimentation $V_{ss}$ et $V_{dd}$. Les tensions à comparer sont, bien entendu celle du noeud 12 et des tensions respectives de seuil $+V_{th}$ et $-V_{th}$ qui, selon une caractéristique importante de l'invention, sont dérivées d'un potentiel unique à savoir celui de la masse. Les transistors de transfert M5 à M8 sont commandés respectivement par le signal d'horloge Ck et l'inverse de ce signal, comme représenté sur la figure 3; ces signaux étant appliqués respectivement sur les bornes 17 et 18 des comparateurs.

En observant cette figure, on s'aperçoit que dans les deux circuits, les noeuds 19 et 20 entre leur transistor de transfert M6 et leurs transistors M2 et M4 sont respectivement connectés à des condensateurs C3 et C4, de faible valeur, typiquement de quelques dizaines de femtofarad. Ces condensateurs permettent de modifier légèrement le potentiel sur les noeuds 19 et 20, respectivement dans le sens positif et dans le sens négatif pour former les tensions $+V_{th}$ et $-V_{th}$ au moment de l'application de l'impulsion d'horloge Ck ou le complément de cette impulsion sur les bornes respectives 17 et 18.

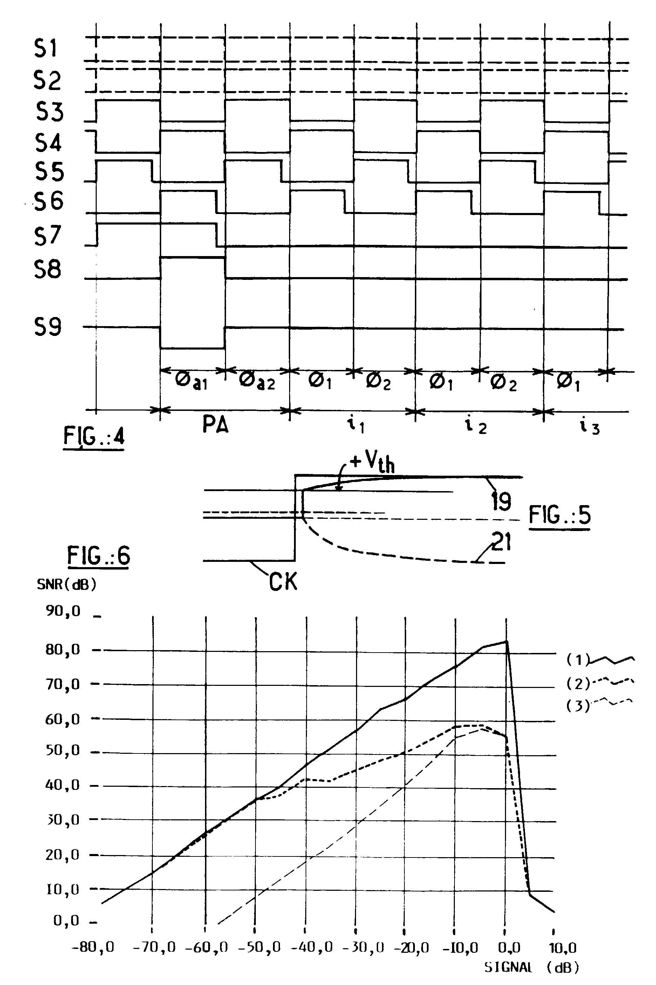

Ce processus est illustré sur la figure 5 pour ce qui concerne le comparateur 15. Il a l'avantage important d'éviter l'utilisation d'un générateur de tensions de seuil en positif et en négatif, le montage étant ainsi moins encombrant et ayant une plus faible consommation. Il est à noter que sur la figure 5, on a représenté par un trait plein la tension du point de jonction 19 (figure 3) au moment où il se produit une transition du signal d'horloge CK, le trait en pointillés représentant l'évolution de la tension sur le noeud 21.

Les sorties des deux comparateurs 15 et 16 apparaissent sur des bornes 21 et 22 respectivement à la jonction entre les transistors M1, M3 et M5 et au noeud 20. Ces sorties aboutissent à un circuit de transformation 23 destiné à produire les valeurs de $b_i$ à partir des signaux élaborés par les comparateurs 15 et 16 selon la table de vérité suivante:

| TABLE DE VERITE | | |
|---|---|---|
| valeur de $b_i$ | borne 21 | borne 22 |
| 0 | 0 | 0 |
| -1 | 0 | 1 |
| +1 | 1 | 0 |

La sortie 24 du circuit 23 est la valeur $b_i$ qui est appliquée à un circuit 25 destiné à produire les mots binaires parallèles en complément à deux représentant les échantillons numériques du signal analogique d'entrée à partir du codage dit (RSD, Redundant Signed Digit). Un tel circuit est décrit dans l'article précité.

En outre, la sortie 24 permet de commander la position des interrupteurs S1 et S2 au cours de l'exécution des itérations de l'algorithme représenté sur la figure 1.

La figure 4 est un chronogramme illustrant le déroulement d'une série d'itérations successives pour obtenir un échantillon de la tension analogique appliquée au convertisseur 4. Chaque train d'impulsions correspond à la commande de l'interrupteur correspondant S1 à S9 de la figure 3. Il est à noter que les trains d'impulsions commandant les interrupteurs S1 et S2 sont représentés en pointillés, car les formes d'onde correspondantes dépendent des valeurs successives du bit ternaire $b_i$ obtenues sur la sortie 24.

Chaque cycle de fonctionnement commence par une phase d'acquisition PA (figure 4) qui est destinée également à établir le bit de poids fort de la valeur de l'échantillon finalement obtenu.

Cette phase d'acquisition se déroule sur deux temps d'horloge $\varphi_{a1}$ et $\varphi_{a2}$. L'interrupteur S7 est encore fermé pendant le temps $\varphi_{a1}$ pour remettre à zéro l'amplificateur 11. Pendant le même temps, l'interrupteur S8 est fermé ce qui place sur le condensateur C2 la valeur de l'échantillon de tension analogique à convertir. Les interrupteurs S4 et S6 sont également fermés. L'interrupteur S9 est ouvert.

Pendant le temps $\varphi_{a2}$, les interrupteurs S3 et S5 sont fermés et les interrupteurs S4 et S6 sont ouverts ce qui copie la charge placée jusqu'ici sur le condensateur C2, sur le condensateur C1. Simultanément, l'un ou l'autre des interrupteurs S1 ou S2 est fermé en fonction du bit de poids fort, les comparateurs 15 et 16 étant amenés à basculer pendant cette phase pour donner ce résultat.

La phase suivante constitue la première itération $i_1$ de l'algorithme qui comme chacune des phases d'itération suivantes se déroule sur deux temps d'horloge.

Pendant le premier temps $\varphi1$, la charge du condensateur C1 est transférée sur le condensateur C2 par la fermeture des interrupteurs S4 et S6, tandis qu'en fonction de la valeur de $b_i$, l'un ou l'autre des interrupteurs S1 ou S2 est fermé. Ceci applique la tension $V_r$ ou la tension O au condensateur de référence Cr. De ce fait, sur le condensateur C2 apparaît une tension constituée du double de la tension $V_x$ majoré de $-b_i*V_r$.

Puis, au cours du second temps $\varphi2$ de cette phase i1, la charge du condensateur C2 est recopiée sur le condensateur C1 par la fermeture des interrupteurs S3 et S5 et l'ouverture des interrupteurs S4 et S6.

Ce processus se répète pendant toutes les itérations suivantes d'un cycle complet jusqu'à ce que le mot binaire complet représentant l'échantillon analogique soit obtenu. Un autre échantillon va alors être pris et traité de la même façon.

La figure 6 montre un graphique illustrant les résultats que l'on peut obtenir grâce à l'invention en matière de rapport signal/bruit. A cet effet, ce rapport a été porté en ordonnées en fonction de l'amplitude d'un signal analogique d'entrée $V_x$ formé par une sinusoïde à 1000 Hz.

Le graphique montre trois courbes numérotées de 1 à 3. La courbe 1 correspond à un convertisseur analogique/numérique parfait à 14 bits dans lequel la multiplication par 2 serait parfaitement exacte. La courbe 2 montre le cas d'un convertisseur analogique/numérique selon l'invention dans lequel le facteur multiplicatif est de 1,998, soit une erreur de 0,2%. La courbe 3 correspond à un convertisseur ayant la même marge d'erreur, mais utilisant un algorithme de calcul classique à deux plages de décision.

On voit donc que la courbe 2 significative quant à l'invention, suit pratiquement une grande partie de la courbe idéale 1 et s'en écarte dans une plage d'amplitude, avec un décalage qui, par définition, est sans conséquence dans l'application envisagée, comme celle des aides auditives.

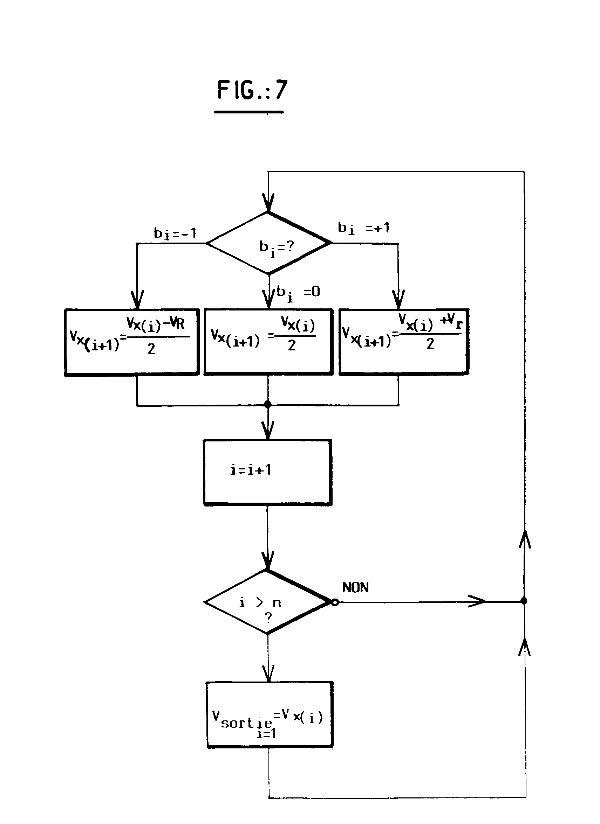

La figure 7 représente l'algorithme mis en oeuvre dans le convertisseur numérique/analogique 6 de la figure 2.

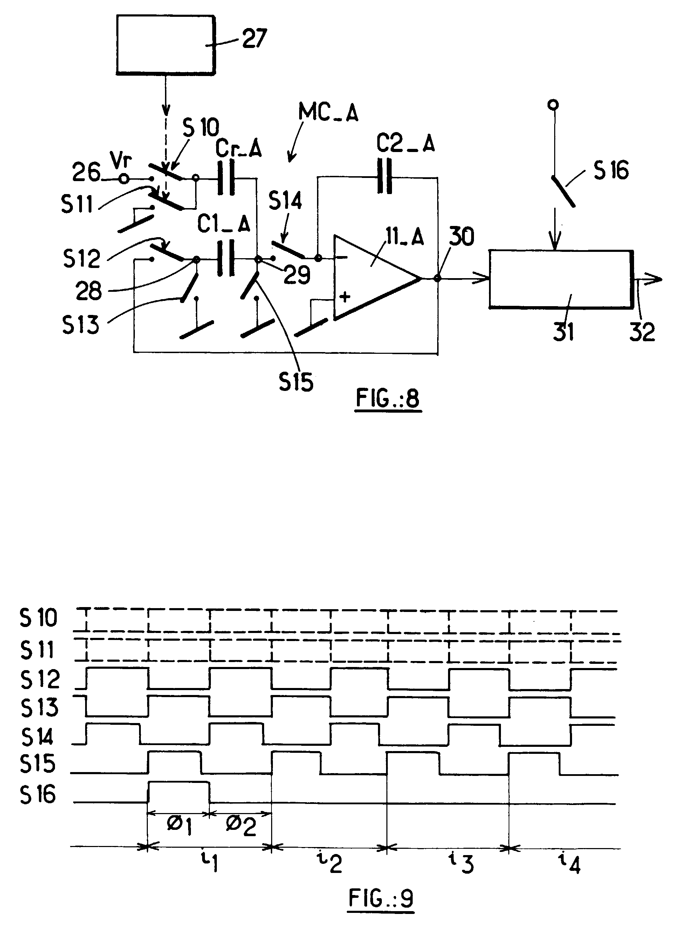

La figure 8 montre un schéma des moyens de calcul MC-A utilisés dans le convertisseur 6. On voit que ce schéma est très semblable à celui des moyens de calcul MC du convertisseur analogique/numérique 4 représenté sur la figure 3.

Ces moyens de calcul MC-A comprennent un condensateur de référence CR-A raccordé à deux interrupteurs S10 et S11 connectés respectivement à une borne 26 d'application de la tension de référence $V_r$ et à la masse. Ces interrupteurs sont commandés en fonction de l'état d'un signal numérique ternaire élaboré à partir du signal fourni par le circuit de traitement 5 dans un circuit de transformation 27. Celui-ci fonctionne sur la base d'un système de transformation dit "CSD" (pour "Canonical Signed Digit") connu en soi. Un tel système est décrit dans un ouvrage de J.M. Müller édité dans la Collection Etudes et Recherches en Informatique et intitulé "Arithmétique des ordinateurs: opérateurs et fonctions élémentaires" (Masson, Paris, 1989).

Le condensateur Cr-A est également connecté à un condensateur C1-A relié entre deux noeuds 28 et 29. Le noeud 28 est connecté à deux interrupteurs S12 et S13. L'interrupteur S12 est connecté à la sortie d'un amplificateur opérationnel 11-A formant un noeud 30. L'interrupteur S13 est connecté à la masse. Le noeud 29 est connecté à un interrupteur S14 relié à l'entrée inverseuse de l'amplificateur opérationnel 11-A, et également à un interrupteur S15 connecté par ailleurs à la masse. L'entrée inverseuse de l'amplificateur opérationnel 11-A est reliée à un condensateur C2-A connecté par ailleurs au noeud 30.

Le noeud 30 est connecté à un circuit de maintien 31 qui peut être déclenché à chaque cycle d'itérations de l'algorithme de calcul au moyen d'un interrupteur S16. Ce circuit fournit sur sa sortie 32 la suite des échantillons de la tension analogique à obtenir.

Dans le cas de la figure 8 la conversion commence par le bit de poids le plus faible (voir également la figure 9). A chaque itération, une charge correspondante, proportionnelle à $b_i*V_r$ est ajoutée à celle du condensateur C2-A. ($b_i$={-1, O ou +1} et la charge totale est divisée par 2.

Chaque itération se déroule sur deux temps d'horloge $\varphi1$ et $\varphi2$, comme dans le cas du convertisseur analogique/numérique 4. Pendant le premier temps d'horloge, le condensateur CR-A se charge à la tension $V_r$ sinon à la tension 0, et la charge du condensateur C1-A est portée à zéro. Pendant le temps $\varphi2$, le condensateur CR-A est chargé à la tension $V_r$ si $b_i$=-1, sinon à la tension 0, et le condensateur C1-A est mis en parallèle avec le condensateur C2-A.

Ainsi, à la fin de chaque temps $\varphi2$, la tension sur le condensateur C2-A sera:

$$V_{C2\text{-}A_{(i+1)}} = \frac{V_{C2\text{-}A_{(i)}} + b_i V_r}{2}$$

A la fin d'un cycle d'itérations, cette tension totale est conservée dans le circuit de maintien 31 jusqu'à l'arrivé du résultat du cycle d'itérations suivant.

A propos des moyens de calcul MC-A que l'on vient de décrire on peut remarquer les mêmes propriétés que celles attachées aux moyens de calcul de la figure 3, savoir une simplicité remarquable.

**Revendications**

1. Convertisseur d'un signal d'entrée en un signal de sortie représentatif dudit signal d'entrée avec une précision relative, ce convertisseur mettant en oeuvre un algorithme de conversion à trois plages de décision impliquant des valeurs numériques ternaires $b_i$, avec $b_i$ = 1, 0, ou -1, et comprenant une source de tension de référence ($V_r$), des moyens de calcul (MC; MC-A) pour, au cours de chacune des itérations d'une suite d'itérations successives dudit algorithme, établir une valeur de tension formée de la somme d'une valeur établie sur la base de la tension calculée à l'itération précédente et d'une valeur qui est le produit de la valeur ternaire obtenue au cours de l'itération précédente et de ladite tension de référence, lesdits moyens de calcul comprenant à cet effet une pluralité de capacités (Cr, C1, C2; Cr-A, C1-A, C2-A) commutées coopérant avec des moyens d'amplification (11; 11A) délivrant ladite valeur de tension à chacune desdites itérations, ledit convertisseur comprenant également des moyens générateurs (14; 31) pour engendrer à partir des valeurs de tension successives calculées pendant ladite suite d'itérations des échantillons successifs représentant sous forme convertie ledit signal d'entrée, caractérisé en ce que lesdits moyens de calcul (MC; MC-A) sont formés par un montage unilatéral de capacités commutées (Cr, C1, C2; Cr-A, C1-A, C2-A) en combinaison avec un unique amplificateur opérationnel (11; 11A) formant lesdits moyens d'amplification, l'une des entrées (+) dudit amplificateur opérationnel étant connectée à un potentiel fixe, et en ce que ladite source de référence est agencée pour fournir une tension de référence unipolaire ($V_r$) référencée sur ledit potentiel fixe.

2. Convertisseur suivant la revendication 1, dans lequel lesdits signaux d'entrée sont analogiques et lesdits signaux de sortie sont numériques, caractérisé en ce que lesdits moyens de calcul effectuent au cours de chacune desdites itérations, l'algorithme de la forme

$$V_{x_{i+1}} = 2V_{x_i} - b_i V_r$$

dans laquelle $V_{x_i}$ est la tension obtenue au cours de l'itération i précédente, $V_{x_{i+1}}$ est la tension à obtenir au cours de l'itération i+1 en cours, $b_i$ est la valeur ternaire -1, 0 ou +1 calculée et $V_r$ est la tension de référence, et en ce qu'il comprend également des moyens de comparaison pour comparer le signal de sortie dudit amplificateur opérationnel à une tension de référence bipolaire ($+V_{th}$, $-V_{th}$) et un circuit logique de transformation (23) pour transformer la sortie desdits moyens de comparaison (15, 16) en les valeurs ternaires utilisées à chaque itération.

3. Convertisseur suivant la revendication 1, dans lequel lesdits signaux d'entrée sont numériques et lesdits signaux de sortie sont analogiques, caractérisé en ce que lesdits moyens de calcul effectuent au cours de chacune desdites itérations, l'algorithme de la forme

$$V_{x_{i+1}} = \frac{\left(V_{x_i} + b_i V_r\right)}{2}$$

dans laquelle $V_{x_i}$ est la portion de tension intermédiaire calculée au cours de l'itération i précédente, $V_{x_{i+1}}$ est la portion de tension intermédiaire à obtenir pendant l'itération i+1 en cours, $b_i$ est la valeur ternaire -1, 0 ou +1 calculée et $V_r$ est la tension de référence, et en ce qu'il comprend également des moyens de maintien pour conserver la tension cumulée obtenue au cours d'un cycle d'itérations précédentes pendant l'exécution d'un cycle d'itérations jusqu'à l'achèvement de celui-ci afin de délivrer les échantillons successifs de la tension analogique à obtenir.

4. Convertisseur suivant l'une quelconque des revendications 1 à 3, caractérisé en ce que l'entrée non-inverseuse dudit amplificateur opérationnel (11; 11-A) est connectée à la masse.

5. Convertisseur suivant l'une quelconque des revendications 1 à 4, à l'exclusion de la revendication 3, caractérisé en ce que lesdits moyens générateurs (14) comprennent deux comparateurs (15, 16) dans chacun desquels l'une des entrées de comparaison est connectée à un condensateur (C3, C4) chargé par un signal de commande (Ck, Ck complément) déclenchant l'opération de comparaison dans le comparateur respectif, ces condensateurs étant par ailleurs reliés à la masse.

6. Dispositif de traitement numérique d'un signal analogique devant être restitué sous une forme analogique, caractérisé en ce qu'il comporte un circuit de traitement numérique (5) à l'entrée duquel est raccordé un convertisseur (4) selon l'une quelconque des revendications 1, 2, 4 et 5 et à la sortie duquel est raccordé un convertisseur selon l'une quelconque des revendications 1, 3 et 4.

7. Dispositif suivant la revendication 6 caractérisé en ce qu'il constitue une aide auditive et en ce que ledit circuit de traitement (5) est destiné à adapter un signal sonore à des propriétés physiologiques d'un patient.

**Patentansprüche**

1. Wandler eines Eingangssignals in ein Ausgangssignal, das das Eingangssignal mit einer relativen Genauigkeit darstellt, wobei dieser Wandler einen Umwandlungsalgorithmus mit drei Entscheidungsbereichen unter Einsatz ternärer digitaler Werte $b_i$ mit $b_i = 1$, 0 oder -1 durchführt und eine Quelle für eine Bezugsspannung ($V_r$) sowie Rechnermittel (MC; MC-A) aufweist, um im Verlaufjedes Iterationsschrittes einer Folge von aufeinanderfolgenden Iterationsschritten des Algorithmus einen Spannungswert zu bestimmen, der aus der Summe eines Wertes, welcher auf der Basis der bei dem vorhergehenden Iterationsschritt berechneten Spannung bestimmt wird, und eines Wertes, der das Produkt aus dem bei dem vorhergehenden Iterationsschritt erhaltenen ternären Wert und der Bezugsspannung ist, gebildet wird, wobei die Rechnermittel zu diesem Zweck mehrere geschaltete Kondensatoren (Cr, C1, C2; Cr-A, C1-A, C2-A) aufweisen, welche mit Verstärkermitteln (11; 11A) zusammenwirken, die den besagten Spannungswert bei jedem der Iterationsschritte liefern, wobei der Wandler ferner aufweist: Erzeugermittel (14; 31) zum Erzeugen aufeinanderfolgender Probenwerte, die in umgewandelter Form das Eingangssignal darstellen, ausgehend von aufeinanderfolgenden Spannungswerten, die während der besagten Folge von Iterationsschritten berechnet wurden, dadurch gekennzeichnet, daß die Rechnermittel (MC; MC-A) von einer unipolaren Zusammenschaltung der Kondensatoren (Cr, C1, C2; Cr-A, C1-A, C2-A) mit einem die Verstärkermittel bildenden einzigen Operationsverstärker (11; 11A) gebildet werden, wobei der eine Eingang (+) des Operationsverstärkers mit einem festliegenden Potential verbunden ist und daß die Bezugsspannungsquelle so ausgebildet ist, daß sie eine einpolige Bezugsspannung ($V_r$) liefert, die auf das festliegende Potential bezogen ist.

2.  Wandler nach Anspruch 1, bei dem die Eingangssignale analog und die Ausgangssignale digital sind, dadurch gekennzeichnet, daß die Rechnermittel im Verlauf jedes der Iterationsschritte den folgenden Algorithmus ausführen:

$$V_{x_{i+1}} = 2V_{x_i} - b_i V_r$$

in der $V_{x_i}$ die bei dem vorhergehenden Iterationsschritt i erhaltene Spannung ist, $V_{x_{i+1}}$ die bei dem Iterationsschritt i+1 zu erhaltende Spannung ist, $b_i$ der berechnete ternäre Wert -1,0 oder +1 ist und $V_r$ die Bezugsspannung ist, und daß er ferner aufweist: Vergleichsmittel zum Vergleichen des Ausgangssignals des Operationsverstärkers mit einer bipolaren Bezugsspannung ($+V_{th}$ - $V_{th}$) und eine Transformationslogikschaltung (23) zum Transformieren des Ausgangssignals der Vergleichsmittel (15, 16) in ternäre Werte, die bei jedem Iterationsschritt verwendet werden.

3.  Wandler nach Anspruch 1, bei dem die Eingangssignale digital und die Ausgangssignale analog sind, dadurch gekennzeichnet, daß die Rechnermittel bei jedem der Iterationsschritte den folgenden Algorithmus durchführen:

$$V_{x_{i+1}} = \frac{(V_{x_i} + b_i V_r)}{2}$$

worin $V_{x_i}$ der bei dem vorhergehenden Iterationsschritt i berechnete Teil der Zwischenspannung ist, $V_{x_{i+1}}$ der bei dem Iterationsschritt i+1 zu erhaltende Teil der Zwischenspannung ist, $b_i$ der berechnete ternäre Wert -1, 0 oder +1 ist und $V_r$ die Bezugsspannung ist, und daß er ferner aufweist: Haltemittel zum Speichern der aufgelaufenen Spannung, die bei einem Zyklus vorhergehender Iterationsschritte während der Durchführung eines Iterationszyklus bis zum Erreichen desselben erhalten wurde, um die aufeinanderfolgenden Probenwerte der zu erhaltenden analogen Spannung abzugeben.

4.  Wandler nach einem der Ansprüche 1 bis 3, dadurch gekennzeichnet, daß der nicht invertierende Eingang des Operationsverstärkers (11; 11A) an Masse liegt.

5.  Wandler nach einem der Ansprüche 1 bis 4 unter Ausschluß des Anspruches 3, dadurch gekennzeichnet, daß die Erzeugermittel (14) zwei Komparatoren (15, 16) aufweisen, bei denen jeweils der eine der Vergleichseingänge mit einem Kondensator (C3, C4) verbunden ist, an den ein Steuersignal (Ck, Ck komplementär) angelegt wird, das den Vergleichsvorgang in dem entsprechenden Komparator auslöst, wobei diese Kondensatoren im übrigen an Masse liegen.

6.  Vorrichtung zur digitalen Aufbereitung eines analogen Signals vor seiner erneuten Darstellung in analoger Form, dadurch gekennzeichnet, daß sie eine digitale Aufbereitungsschaltung (5) aufweist, an deren Eingang ein Wandler (4) gemäß einem der Ansprüche 1, 2, 4 und 5 angeschlossen ist und an deren Ausgang ein Wandler gemäß einem der Ansprüche 1, 3 und 4 angeschlossen ist.

7.  Vorrichtung nach Anspruch 6, dadurch gekennzeichnet, daß sie eine Hörhilfe bildet und daß die Aufbereitungsschaltung (5) dazu dient, ein Tonsignal an die physiologischen Eigenschaften eines Patienten anzupassen.

**Claims**

1.  Converter of an input signal into an output signal representing the said input signal with a relative precision, this converter implementing a conversion algorithm with three decision ranges involving ternary digital values $b_i$ with $b_i$ = 1, 0, or -1, and comprising a reference voltage source ($V_r$), means of computation (MC; MC-A) for, in the course of each of the iterations of a sequence of successive iterations of the said algorithm, determining a voltage value formed by the sum of a value determined on the basis of the voltage computed in the previous iteration and of a value which is the product of the ternary value obtained in the course of the previous iteration and of the said reference voltage, the said means of computation comprising for this purpose a plurality of switched capacitances (Cr, C1, C2; Cr-A, C1-A, C2-A) cooperating with amplification means (11; 11A) delivering the said voltage value in each of the said iterations, the said converter also comprising generator means (14; 31) for producing, from the successive voltage values computed during the said sequence of iterations, successive samples representing, in converted form, the said input signal, characterized in that the said means of computation (MC; MC-A) are formed by a unilateral arrangement of switched capacitances (Cr, C1, C2; Cr-A, C1-A, C2-A) in combination with a single operational amplifier (11; 11A) forming the said amplification means, one of the inputs (+) of the said operational amplifier being connected to a fixed potential, and in that the said reference source is devised so as to provide a unipolar reference voltage ($V_r$) referenced to the said fixed potential.

2. Converter according to Claim 1, in which the said input signals are analogue and the said output signals are digital, characterized in that the said means of computation perform, in the course of each of the said iterations, the algorithm of the form

$$V_{x_{i+1}} = 2\,V_{x_i} - b_i V_r$$

in which $V_{x_i}$ is the voltage obtained in the course of the previous iteration i, $V_{x_{i+1}}$ is the voltage to be obtained in the course of the iteration i+1 in progress, bi is the computed ternary value -1, 0 or +1 and $V_r$ is the reference voltage, and in that it also comprises comparison means for comparing the output signal from the said operational amplifier with a bipolar reference voltage ($+V_{th}$, $-V_{th}$) and a transformation logic circuit (23) for transforming the output from the said comparison means (15, 16) into the ternary values used in each iteration.

3. Converter according to Claim 1, in which the said input signals are digital and the said output signals are analogue, characterized in that the said means of computation perform, in the course of each of the said iterations, the algorithm of the form

$$V_{x_{i+1}} = \frac{(V_{x_i} + b_i V_r)}{2}$$

in which $V_{x_i}$ is the intermediate voltage portion computed in the course of the previous iteration i, $V_{x_{i+1}}$ is the intermediate voltage portion to be obtained during the iteration i+1 in progress, $b_i$ is the computed ternary value -1,0 or +1 and $V_r$ is the reference voltage, and in that it also comprises holding means for retaining the cumulated voltage obtained in the course of a cycle of previous iterations during the execution of a cycle of iterations until the latter is completed so as to deliver the successive samples of the analogue voltage to be obtained.

4. Converter according to any one of Claims 1 to 3, characterized in that the non-inverting input of the said operational amplifier (11; 11-A) is connected to earth.

5. Converter according to any one of Claims 1 to 4, with the exclusion of Claim 3, characterized in that the said generator means (14) comprise two comparators (15, 16) in each of which, one of the comparison inputs is connected to a capacitor (C3, C4) charged via a control signal (Ck, Ck complement) triggering the comparison operation in the respective comparator, these capacitors being moreover earthed.

6. Device for the digital processing of an analogue signal required to be restored in an analogue form, characterized in that it includes a digital processing circuit (5) to the input of which is joined a converter (4) according to any one of Claims 1, 2, 4 and 5 and to the output of which is joined a converter according to any one of Claims 1, 3 and 4.

7. Device according to Claim 6, characterized in that it constitutes a hearing aid and in that the said processing circuit (5) is intended to adapt a sound signal to physiological properties of a patient.

## FIG.: 1

$$V_{x(1)} = V_{in}$$
$$i = 1$$

$V_{x(2)} > V_{+h}$   ?   $V_{x(2)} < -V_{th}$

si NON

$$b_i = 1$$
$$V_{x(i+1)} = 2V_{x(i)} - V_r$$

$$b_i = 0$$
$$V_{x(i+1)} = 2V_{x(i)}$$

$$b_i = -1$$
$$V_{x(i+1)} = 2V_{x(i)} + V_r$$

$$i = i+1$$

OUI   $i > n$ ?   NON

## FIG.:2

FIG.:3

Sortie vers 5 (FIG.:2)

FIG.:4

S1
S2
S3
S4
S5
S6
S7
S8
S9

$\varnothing_{a1}$  $\varnothing_{a2}$  $\varnothing_1$  $\varnothing_2$  $\varnothing_1$  $\varnothing_2$  $\varnothing_1$

PA    $i_1$    $i_2$    $i_3$

FIG.:5

$+V_{th}$

19

21

CK

FIG.:6

SNR(dB)

90,0
80,0
70,0
60,0
50,0
40,0
30,0
20,0
10,0
0,0

(1)
(2)
(3)

-80,0  -70,0  -60,0  -50,0  -40,0  -30,0  -20,0  -10,0  0,0  10,0

SIGNAL (dB)

# FIG.: 7

FIG.:8

FIG.:9

14